Europäisches Patentamt

European Patent Office

Office européen des brevets

(19)

(11) Publication number: **0 290 258 B1**

# EUROPEAN PATENT SPECIFICATION

(12)

(45) Date of publication of patent specification: **16.09.92**

(51) Int. Cl.5: **C30B 11/12**, C30B 29/62

(21) Application number: **88304083.4**

(22) Date of filing: **05.05.88**

(54) VLS fiber growth process.

(30) Priority: **05.05.87 US 46829**

(43) Date of publication of application:
**09.11.88 Bulletin 88/45**

(45) Publication of the grant of the patent:
**16.09.92 Bulletin 92/38**

(84) Designated Contracting States:
**DE FR GB**

(56) References cited:
**DE-A- 2 036 604**
**FR-A- 2 592 399**
**US-A- 3 622 272**
**US-A- 4 612 138**

**CHEMICAL ABSTRACTS, vol. 91, no. 20, November 1979, page 121, abstract no. 159811r, Columbus, Ohio, US; & JP-A-79 40 286 (SANKYO ORGANIC CHEMICALS CO., LTD) 29-03-1979**

(73) Proprietor: **THE STANDARD OIL COMPANY**
**200 Public Square, 36-F-3454**
**Cleveland Ohio 44114(US)**

(72) Inventor: **Fox, Joseph R.**
**35906 Meadowdale Drive**
**Solon Ohio 44139(US)**
Inventor: **White, Douglas A.**
**1007 Williams Road**
**Cleveland Heights Ohio 44121(US)**

(74) Representative: **Scott, Susan Margaret et al**
**BP INTERNATIONAL LIMITED Patents & Agreements Division Chertsey Road Sunbury-on-Thames Middlesex TW16 7LN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The present invention relates generally to the growth of inorganic fibers via the vapor-liquid-solid process. More particularly, it relates to an improvement in the process concerning the formation of fiber growth promoters on substrate material. An embodiment is disclosed in which a substrate is prepared for the growth of silicon carbide fibers or whiskers.

The mechanism of VLS (vapor-liquid-solid) growth of inorganic fibers, or filamentary "whisker" crystals of silicon and other materials, including silicon carbide, was first proposed by Wagner and Ellis in The Vapor-Liquid-Solid Mechanism of Crystal Growth and its Application to Silicon, Transactions of the Metallurgical Society of AIME, 233, 1053 (1965). According to the VLS mechanism, in the vapor deposition of crystalline material such as silicon onto a substrate, a droplet of liquid is situated between the vapor and the growing crystal. The surface of the liquid is a preferred site for deposition from the vapor. The liquid becomes supersaturated with material supplied by the vapor, and crystal growth occurs by precipitation at the solid-liquid interface.

The mechanism was supported by the observations that whiskers of crystals of $Al_2O_3$, SiC, and BeO had rounded terminations at their tips, regrown silicon whiskers exhibited a liquidlike globule at the tip, and certain impurities were essential to silicon whiskers, rather than film, growth.

It was determined that the impurities identified were whisker growth promoting agents which formed a liquid solution with the crystalline material to be grown at the deposition temperature. This growth promoting agent was found in the hemispherical terminations of the tips of the VLS grown whiskers. Silicon was suggested as a growth promoting agent for SiC whiskers.

The formation of inorganic fibers, such as SiC, by the VLS process has been investigated by the contacting, with a reactive gas, of a growth promoter containing substrate at elevated temperature. The reactive gas contained components of the fiber to be deposited, such as silicon and carbon for SiC fibers. Generally, growth of the fibers has been observed roughly normal to the surface of the substrate, the growth promoter tip being disposed on the end of the fiber opposite the substrate.

For example, U.S. Patent No. 3,519,472 describes the growth of silicon carbide whiskers having a knob of an alloy of iron and silicon, sometimes in combination with nickel, titanium or other metals, generated by the reaction of silicon monoxide, carbon monoxide and hydrogen over substrates of silicon nitride, silicon carbide, alumina or carbon, where the metal was present in the substrate or the refractory brick lining the high temperature reaction furnace.

Fiber growth promoter materials proposed include metals, alloys and compounds of iron, nickel, manganese, chromium and titanium.

Silicon carbide fibers or whiskers have shown suitability for use as reinforcing materials for composites, in which the matrix material may be polymeric resins, glasses, silicon, aluminum, copper or another ceramic, such as $Si_3N_4$ or $Al_2O_3$.

In order to be commercially viable, SiC fibers produced by the VLS process must exhibit reproducibility regarding length and diameter, parameters which in previous embodiments have varied by as much as 100% from one production run to the next. U.S. Patent No. 3,519,472 supra reports a tenfold difference in length to thickness ratios of from 10:1 to 100:1.

We have traced this problem to the preparation of the substrate material for the reaction, particularly the treatment of the substrate with fiber growth promoter material.

Various methods for treating the substrate with the fiber growth promoter material have been proposed. Application of the material onto a roughened substrate was proposed in U.S. Patent No. 3,692,478; sprinkle, powder or vapor deposition in U.S. Patent No. 3,721,732; and brush, dust or vapor deposition in U.S. Patent No. 4,013,503. In U.S. Patent No. 3,622,272 it was proposed to apply the material by brushing on the substrate a powdered metal suspended in a liquid vehicle, exemplified as an equal volume of acryloid resin and an alcohol. In U.S. Patent No. 3,778,296, it was proposed that a layer of carbon (such as charcoal), growth promoter and synthetic or natural lacquer (in a solvent) be applied with a brush onto the substrate.

One conventional method for preparing substrates for SiC fiber production is di ping in or brushing onto a substrate, a binder mixture, such as polymethylmethacrylate and fumed silica in methylethylketone, and sprinkling onto the coated substrate, the fiber growth promoter as a metal powder.

These conventional methods of preparing substrates generally produce inhomogeneous substrates in which the particle size range of fiber growth promoter material is large, and the distribution of such particles over the substrate surface is disordered, often with gaps existing on the surface.

In addition, when the ratio of binder to promoter is too large, a less active carbon rich promoter is formed, and black undergrowth is formed on the substrate among the green $\beta$-SiC fibers. When the ratio of binder to promoter is too small, the promoter material powders are not bound to the substrate, and are lost.

Further, vapor deposition techniques require expensive capital instruments to carry out the deposition, with commercial scaleup being questionable.

It is necessary, therefore, for economic commercialization of fibers of the desired uniform qualities and characteristics that an inexpensive and a more reproducible method of preparing substrates be employed.

The present invention is directed to an improved process for producing inorganic fibers by the VLS process. The invention is further directed to a simple and inexpensive method of preparing substrates for the VLS production of inorganic fibers.

The method of preparing such substrates provides a homogeneous, ordered distribution of adherent, active particles of fiber growth promoting material on at least one surface of the substrate. This preparation method minimizes the nonuniform undergrowth of material among the fibers produced by the VLS process.

The VLS reaction substrate preparation method of the present invention includes forming a sol containing a fiber growth promoter material precursor and applying said sol to the substrate. The sol further comprises a solvent for the precursor which as a sol is capable of wetting the surface of the substrate.

The present invention also includes a method of producing inorganic fibers by a VLS process including contacting the substrate, prepared as above, with gaseous components of the fibers to be produced, at VLS reaction temperatures. When SiC fibers are to be produced, a SiC fiber growth promoter material is utilized, and the substrate is contacted with silicon and carbon containing gases.

Accordingly, the present invention provides a method of preparing a substrate for the VLS preparation of inorganic fibers, which comprises applying to at least one surface of a substrate, a fiber growth promoter material precursor; characterised in that the fiber growth promoter material precursor is applied to the surface in the form of a sol comprising colloidal particles of less than or equal to 1 micron in size, said sol being capable of wetting the surface, which is thereafter dried. The invention further provides a method for preparing inorganic fibers by a VLS process, which comprises preparing a substrate by the method of the invention, and contacting said substrate with gaseous components of said fibers at VLS reaction temperature. Preferably, said sol coated substrate is heat treated prior to contacting with said gaseous components.

The sol may be formed of colloidal hydrous metal oxide particles in a liquid, said metal oxide being said fiber growth promoter material precursor and said liquid being capable of dissolving a salt of said metal and of wetting the substrate surface as a sol. If desired, the liquid may contain a surfactant. Preferred metals are selected from iron, manganese, nickel, cobalt, chromium, molybdenum, lanthanum and mixtures thereof.

Preferably, said sol coating is formed by adding a base to an alcohol solution of a salt of at least one metal selected from iron, manganese, nickel, cobalt, chromium, molybdenum, lanthanum and mixtures thereof to precipitate out colloidal hydrous oxides of said metal. The alcohol is preferably methanol, ethanol or propanol, and the base is preferably selected from ammonium hydroxide, tetramethylammonium hydroxide, tetraethylammonium hydroxide, tetrapropylammonium hydroxide, sodium hydroxide, calcium hydroxide, trimethylamine, triethylamine, ethylenediamine, ammonia, or mixtures thereof.

In a preferred process according to the invention, SiC fibers are produced, and the process includes the steps of contacting said coated substrate with silicon and carbon containing gases at a temperature of about 1300°C to about 1500°C.

Brief Description of the Drawings

Figure 1 is a scanning electron micrograph (magnification 50X) of a heat treated (1400°C under argon) VLS graphite substrate coated with a hydrous iron oxide methanol sol, pH 7, according to the present invention.

Figure 2 is a scanning electron micrograph (magnification 100X) of a heat treated (1400°C under argon) VLS graphite substrate coated with a hydrous iron/chromium/nickel oxide/methanol sol, pH 10, according to the present invention.

Figure 3 is a scanning electron micrograph (magnification 390X) of a heat treated VLS graphite substrate coated with a hydrous iron oxide/$H_2O$ sol, pH 7.

Figure 4 is a scanning electron micrograph (magnification 240X) of a VLS graphite substrate dip coated with binder and sprinkled with iron/silicon alloy particles.

The present invention is directed to the preparation of a substrate for the production, by the VLS process, of inorganic fibers, involving forming a sol from a liquid which has good wetting properties with regard to the substrate material, which liquid is a solvent for and contains a fiber growth promoter material precursor, and applying the sol to the substrate.

As used in this specification, the term "fibers" shall mean inorganic materials having a diameter of about 0.5 microns to about 50 microns, and a length of about 10 to about 10,000 times their diameter.

Included in this definition are the "whiskers" as described above.

Also as used in this specification, the term "sol" refers to a colloidal suspension of particles, and according to the invention comprises a colloidal suspension of hydrous metal oxide particles which have been precipitated from a soluble metal salt dissolved in a solvent which is capable of wetting the substrate material as a sol. The colloidal particles are generally less than or equal to one micron in size.

Substrates which can be used according to the present invention include graphite, glassy carbon, silicon carbide, alumina, and silicon nitride, however graphite, or another material such as glassy carbon, which is mildly reactive with the fiber growth promoter material at either heat treating or VLS reaction temperatures is preferred. This mild reactivity aids in bonding the promoter to the substrate prior to the fiber growth process, and also in reducing the precursor oxide to the active metal species. Substrates which are not reductants for the promoter are also suitable, as hydrogen in the VLS process gas can convert the oxide to metal.

Fibers which can be produced according to the invention include beta-silicon carbide ($\beta$-SiC), silicon, graphite, silicon nitride or other fibers grown by a VLS type mechanism. The fibers are produced by contacting the promoter-treated substrate at VLS reaction temperatures with gaseous components of the fibers to be produced. The invention has been shown to be particularly effective in the production of silicon carbide fibers.

Fiber growth promoter materials suitable for use in the present invention include those which are effective in promoting SiC fiber growth, and include iron, manganese, nickel, cobalt, chromium, molybdenum, lanthanum and mixtures, compounds, or alloys thereof. Preferred combinations are iron/nickel/chromium and iron/nickel.

According to the method of the invention, the fiber growth promoter material is applied to the substrate as a component of a sol. The sol is formed by introducing a base into a liquid solution of a soluble salt of the desired fiber growth promoting metal or metals, the liquid being capable of wetting the substrate material as a component of the sol and being preferably organic, most preferably a low molecular weight alcohol. By way of example, but not limitation, the formation of a hydrous iron oxide/ methanol sol is described below.

Sol Preparation

A hydrous iron oxide/methanol sol was prepared by titrating 2.43g of $Fe(NO_3)_3 \cdot 9H_2O$ in 100ml methanol with concentrated $NH_4OH$ until the solution reached pH = 7 as read by a pH meter (it being noted that pH generally characterizes aqueous systems). The solution formed a precipitate that was allowed to settle in a closed container. After settling was completed, 35ml of the clear, supernatant liquid was removed, leaving only the portion of the solution in which the hydrous iron oxide had settled as a sol.

During titration of the iron nitrate solution, relatively high molecular weight polycations were formed which served as precursors to the colloidal dispersions (sols) that were formed. Preferably, the solutions were not titrated to an exact equilibrium, so that the sols which were formed contained hydrous iron oxides which precipitated out of solution.

It is thought that the hydrous metal salt undergoes deprotonation and condensation reactions in the presence of base to form colloidal hydrous metal oxide particles of the formula $M_nO_w(OH)_x(H_2O)_y X_z$ in which M is a metal such as iron, X is the anion of the reactant salt, and $w + x + y + z$ maintains charge neutrality with, and meets valence requirements of, the metal M. Control of the extent of precipitation controls the uniformity and magnitude of the particle sizes and ultimately the fiber diameter.

The iron/methanol sol was thoroughly shaken to resuspend settled particles to provide a uniform suspension before application to the substrate surface.

In the sol preparation method as described above, salts of the fiber growth promoter metal are utilized which are soluble in the liquid solvent chosen for the sol. Examples of suitable salts in addition to nitrates include halides such as chlorides, bromides or iodides, and others such as acetates, oxalates, perchlorates, sulfates, phosphates and the like. Nitrates are preferred.

The liquid solvent chosen must produce a sol with the addition of an inorganic or an organic base to the metal salt/solvent solution. Examples of suitable liquid solvents include water, for some substrates, and organic liquids Organic liquids include alcohols such as methanol, ethanol, and isopropanol, and other organics including ketones such as acetone and methylethylketone, and ethers such as diethyl-, dimethyl- or methylethyl-ether and the like. Preferably an alcohol such as methanol is utilized.

The concentration of fiber growth promoter material precursor in solution before pH adjustment is generally about 0.001M to about 0.5M, and when iron is utilized, preferably about 0.006M to about 0.1M.

The bases used to form the sol upon titration of the metal salt/solvent solution may contain a hydroxide

EP 0 290 258 B1

ion and include ammonium hydroxide, tetramethyl-, tetraethyl- or tetrapropyl-ammonium hydroxide, and inorganic hydroxides such as sodium or calcium hydroxide. Suitable amine bases include trimethylamine, triethylamine, or ethylenediamine. Ammonia can be used, preferred is ammonium hydroxide.

The pH of the metal salt/solvent solution upon addition of the base should be adjusted to at least about 7 (when the solvent is organic, in a relative sense, that is, as read by a pH meter), and preferably is in the range of 7 to 10. Sols formed with pH adjustment to less than about 7, when applied to substrates as described below, lead to nonuniform deposition of the fiber growth promoter material precursors. In the case of mixed promoters, the pH should be adjusted to a level such that all desired components precipitate out.

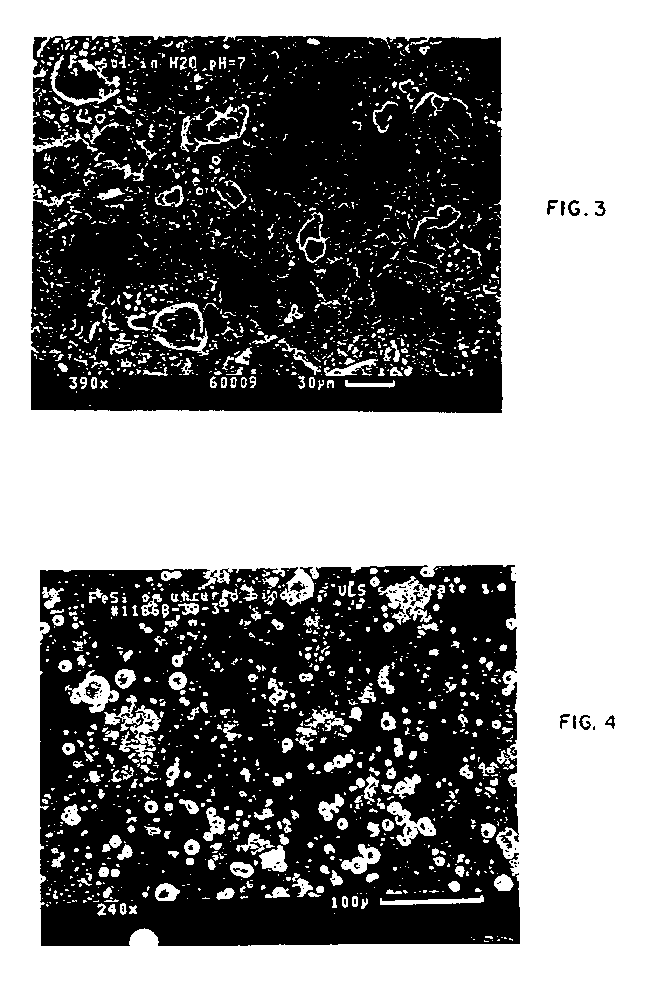

The failure to adequately wet the substrate surface, resulting in nonuniform promoter material precursor deposition was also observed when an iron/water sol was used in the substrate preparation method Fig. 3 for a graphite substrate. In these instances, iron separated out and agglomerated in areas, resulting in local differences in iron concentration upon drying.

The supernatant liquid is preferably removed from the metal oxide/solvent sol before application to the substrate, in order to avoid the formation of deposits of salt, such as $NH_4(NO_3)$ used in the example above, or other impurities on the substrate. If present, these impurities could deleteriously affect inorganic fiber uniformity.

In an alternative embodiment, the sol can be prepared by introducing sized metal oxide particles, such as iron oxide pigments into the liquid capable of wetting the substrate.

Substrate Treatment

The sol solution can be applied to the substrate by dipping, brushing, spin coating, using a draw bar and most preferably, by pipetting to achieve reproducible loadings of fiber growth promoter material. No binder is required, as the sol adheres directly to the substrate surface. Thus, the sols used in the present invention are essentially free of binder.

The volume of sol to be applied to the substrate can vary according to concentration of components, consistency of the sol and size of the substrates. The sol prepared as described above was applied to a 2 inch by 2 inch graphite substrate in an amount of 1ml to 3.5ml, preferably 2.5ml, covering one surface. The sol was allowed to dry in air, and gave a coating of about 40mg to about 150mg, preferably 65mg on each 2 inch by 2 inch square.

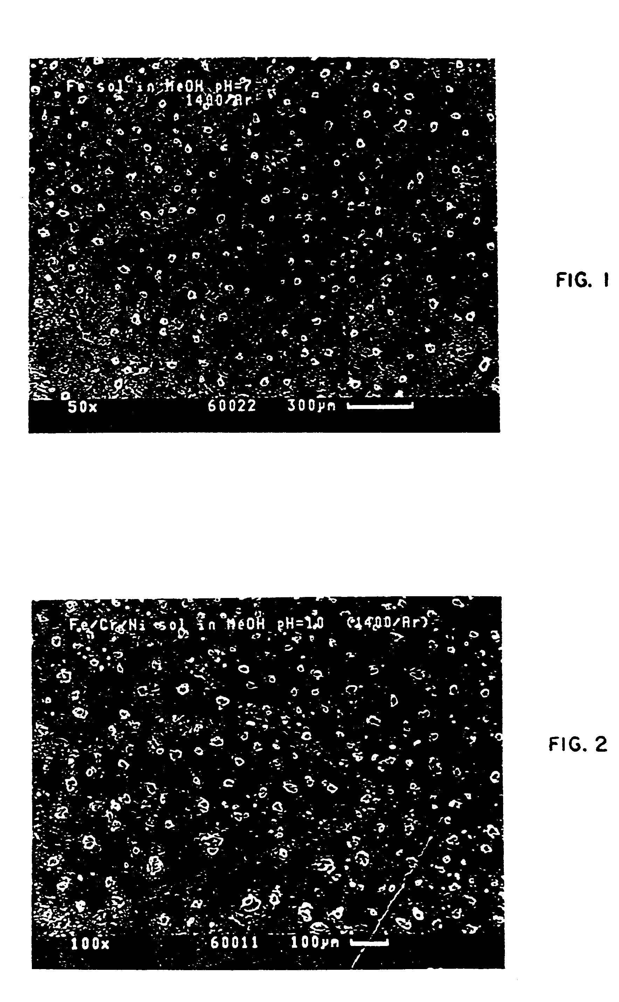

The dried coating produced a uniform iron oxide coating on the substrate Fig. 1, which adhered to the substrate such that it could be inverted (in the conventional VLS position) without the fiber growth promoter precursor falling off. Care should be exercised not to load the sol too thickly, as this may cause the material to flake off upon drying.

Drying at or near ambient temperature provides "islands" of coating material which may give rise to promoter particles upon heating above 1000°C. By varying concentration and/or amount of sol applied, the size of the islands, the size of the growth promoter particles and ultimately the diameter of the fibers to be produced can be controlled. This cannot be achieved with conventional substrate preparation methods.

In order to form discrete particles of the fiber growth promoter material on the substrate to serve as nucleation sites for fiber growth, the sol coating is heat treated. Preferably, the treatment includes heating the coated substrate under an argon atmosphere at a temperature of about 1000-1500°C, preferably 1400-1425°C, either as a separate step or as the startup procedure of a VLS reaction. Other inert gases can also be utilized in addition to or instead of argon.

Promoter material may react with the substrate at the heat treatment temperatures. For example, particles of iron oxide reacted with the graphite substrate such that they adhered tenaciously and could be removed only by scraping. Above 1000°C, the iron oxide is reduced by graphite to give particles of iron imbedded in slight holes on the graphite.

VLS Reaction-Formation of SiC

The VLS process and reaction conditions are known for many inorganic fibers. In accordance with one embodiment of the present invention, the VLS reaction is performed by heating the sol coated substrates over a carbon/silicon dioxide bed to 1300-1500°C, preferably 1400-1425°C under argon or other inert gas. The gas flow is then changed to a mixture of hydrogen, carbon monoxide, nitrogen and methane, and the fiber producing reaction is allowed to proceed. During the reaction, the $C/SiO_2$ bed generates silicon monoxide (SiO) via the following reactions:

5

$$C + SiO_2 \rightarrow CO + SiO \quad (I)$$

or

$$SiO_2 + H_2 \rightarrow SiO + H_2O \quad (II)$$

where both the reactions I and II equilibriums are controlled by the flow of the reactive gases. The major function of hydrogen in the gas mixture, however, is thought to be the maintenance of the fiber growth promoter material in a reduced state.

The SiO formed from the $C/SiO_2$ bed and carbon from the $CH_4$ feed are absorbed by the fiber growth promoter material dispersed on the substrate. When the molten promoter material becomes saturated with the two species, SiC precipitates out in the form of single crystal fibers. Contact time can vary.

We have found that the utilization of SiO and SiC fiber growth can be enhanced by beginning the gas flow of the $H_2/CO/N_2/CH_4$ mixture just before the $C/SiO_2$ reaction temperature is reached, so that CO is present to prevent overproduction of SiO (according to reaction I) which might otherwise react with the promoter such as iron without carbon present to produce a silicon-rich alloy less active for growing fibers. The gas mixture should not be started too soon, however, to prevent hydrogen from causing deleterious effects on the promoter distribution such as puddling.

Reactive gas mixtures for VLS reactions are known as well as variations in molar ratios of the reactants. A typical atmosphere for conducting a VLS silicon carbide fiber growth process is 82% hydrogen, 10% carbon monoxide, 7.5% nitrogen and 0.5% methane. To generate SiO from a $C/SiO_2$ bed, the ratio of the reactants is not critical, however, a 2.5:1 molar ratio of C to $SiO_2$ has been utilized and is preferred. In other embodiments, $SiH_4$ or other gaseous silanes may be used as a silicon source.

EXAMPLES

The examples below are intended to illustrate, but not to limit, the present invention.

The heat treatment and VLS reactions described below and reported in Table I were conducted in a horizontal tube furnace with the temperature controller modified to allow for ramping capabilities. All samples were reacted inside an alumina tube 36 inches long, having an inner diameter of 2.75 inches and an outer diameter of 3 inches. The ends of the alumina tube were sealed (aluminum plates with a Viton gasket) and connected to a controlled gas flow system. Controlling and monitoring thermocouples were outside the alumina tube in the furnace.

A 10" long, hollowed out graphite boat with holes cut in the ends to allow for uninterrupted gas flow through the reaction zone was used as a reaction vessel. For VLS reactions, 25g of a 2.5:1 $C/SiO_2$ mixture (molar ratio) in the form of Thermax carbon black and Fisher Scientific 325 mesh silica, was placed in the hollowed out portion of the boat. Two graphite substrates with the promoter material coating facing downward over the top of the $C/SiO_2$ bed were set on top of the reaction vessel, flanked by two uncoated graphite substrates. (The scope of the present invention includes utilizing substrates with promoter material facing upward or to the side, depending upon reactor configuration.) Reactor tube volume was calculated to be 176.7 cubic inches.

The reaction vessel was placed in the center of the alumina tube with approximately 6 inches of graphite insulating bricks on either side of it. The tube was sealed, and evacuated to a pressure of 200mTorr. The tube was back filled with argon to atmospheric pressure, and once purged with argon, the sample was heated to 1400°C over a 3 hour period with Ar flow of 200 cc/min.

For VLS reactions, the gas mixture of $H_2/CO/N_2/CH_4$ was introduced and the reaction allowed to proceed at 1425°C for 10 hours.

Examples 1-12

Graphite substrates were prepared for VLS reaction according to the following procedure. 2.43g of Fe-$(NO_3)_3 \cdot 9H_2O$ was dissolved in 100ml of methanol to form a 0.06M solution of iron. The solution was titrated with concentrated $NH_4OH$ to obtain a pH meter reading of 7. A brown-orange precipitate formed that was allowed to settle out in a closed container. 35ml of the supernatant was removed to give the sol solution. About 2.5cc of the sol was pipetted onto each of the 2 inch by 2 inch graphite substrates to cover one surface entirely. The amount of sol applied to each substrate after drying is reported in Table 1.

The sol covered substrates were allowed to dry in air for about one hour, with a hydrous iron oxide coating forming on the surface of the substrate.

The sol coated substrates were then placed on top of the graphite reaction boat, with the coated side facing downward. The boat was then fired inside the alumina tube after evacuation with Ar flowing at 200cc/min. The temperature was ramped at 7.7°C/min to 1400°C where it was held for 5-10 minutes.

The resulting product was a VLS substrate with a surface containing a relatively uniform distribution of mono-sized, securely bound iron particles, Fig. 1. The average size of the particles on the substrate Fig. 1 as determined by scanning electron microscopy (SEM) fell into the 30-50 micron range with about 100 microns between the particles. Energy dispersive spectroscopic (EDS) analysis of the substrates showed no residual iron between the particles, representing an ideal surface for use in a VLS reaction.

The substrates prepared as above were utilized in pairs in a VLS reaction to form SiC fibers. For Examples 1-8, the reaction gas mixture of $H_2$ (200 cc/min), CO (25 cc/min), $N_2$ (18.75 cc/min) and $CH_4$ - (1.25 cc/min) was introduced into the reactor in time to purge it before the temperature reached 1425°C, that is, the flow was begun about 12 minutes prior to the reactor reaching 1425°C. For Examples 9-12, the flow rate of each component was halved, and the mixture flow was started about 23 minutes before the temperature reached 1425°C.

Ten hours of reaction yielded green $\beta$-SiC fibers, approximately 1 inch long and on average, 10 microns in diameter. The SiC fibers were attached to the substrate at one end, and contained a small sphere of FeSi alloy at the other end. The results of the VLS reaction runs are set forth in Table 1, below.

## TABLE I

### RESULTS OF VLS REACTION

| EXAMPLE NO. | SOL WT. (gm) | GAS FLOW (cc/min) | FIBER YIELD $(mg/cm^2)$ |
|---|---|---|---|
| 1 | 0.0601 | 245.0 | 2.70 |
| 2 | 0.0612 | " | 2.39 |
| 3 | 0.0419 | " | 2.07 |
| 4 | 0.0532 | " | 2.69 |
| 5 | 0.0743 | " | 2.21 |
| 6 | 0.0688 | " | 2.22 |
| 7 | 0.0658 | " | 2.31 |
| 8 | 0.0701 | " | 2.51 |
| 9 | 0.0669 | 122.5 | 2.69 |
| 10 | 0.0715 | " | 3.02 |
| 11 | 0.0592 | " | 2.51 |
| 12 | 0.0615 | " | 2.72 |

### Example 13

A mixed promoter containing sol was prepared in methanol to provide a promoter of composition 69.4% Fe, 16.5% Cr and 14% Ni (by weight) from their respective nitrate salts. Titration with $NH_4OH$ was carried out until the pH meter reading was equal to 10 to ensure precipitation of all three metals in the solution. The sol was applied to graphite substrates and was heat treated to 1400°C under argon. The particle distribution of promoter material on the surface of the substrates Fig. 2 was uniform and similar to that exhibited by the iron/methanol sols, above. EDS analysis indicated that all three metals were present in approximately the theoretical concentrations.

Based upon the disclosure of this specification, the pH adjustment for combinations of metal components according to this invention can be determined experimentally by those skilled in the art. For example, pH of 7 was not sufficient to precipitate out all of the metal components of example 13, while pH of 10 was, and a pH of 10 did not render uniform particle distribution of a 50/50 Fe/Mn combination. Within the disclosure of the invention, however, these variations can be readily recognized and compensation or adjustments made.

### Comparative Example A

An iron/water sol was prepared and applied to graphite substrates according to the procedure outlined for examples 1-12. After heat treatment in argon, the substrate surface exhibited nonuniform particle distribution Fig. 3. The iron particles were oddly shaped and scattered randomly, with the average particle size determined by quantitative image analysis to be 55 microns, with 74.3% of the particles between 35 and 75 microns. The water based sols exhibited a slower drying time than the organic based sols.

The poor substrate wetting ability of the water based sol for graphite substrates as compared to the organic based sol gave an uneven coating which resulted in a worse iron particle distribution upon heating. Although water based sols are not suited according to the present invention for use with graphite substrates, they are suitable for use with substrates the surface of which they wet uniformly. In another embodiment, a surfactant can be added to the aqueous sol such that wetting of graphite is achieved. Suitable surfactants include water soluble ionic or nonionic surfactants. Examples of suitable surfactants include, but are not limited to, Fluoread SC-99 (a tradename for fluorochemical surfactant) and Triton X-100 (tradename for an alkylarylpolyether alcohol).

Paired graphite substrates coated with an iron/water sol were tested in a VLS reaction according to the procedure set forth above, and produced much lower than average SiC yields of 1.51 and 1.12 mg/cm$^2$.

Comparative Example B

Graphite substrates were prepared according to the conventional method of dipping one face of a 2 inch by 2 inch substrate into a binder solution of 100g polymethylmethacrylate, 100g methlethylketone (MEK) and 3g of a fumed silica (Cabosil, obtained from Cabot Corporation). The substrate was dried at 80°C for 30 min. and reweighed. The promoter alloy powder, $Fe_{80}Si_{20}$, obtained from Alloy Metals, Inc. was sprinkled onto the coated substrate through a -400 mesh sieve. A weight of 11 to 20mg of the powder was obtained by tapping the substrate until the correct weight was reached. The substrate/binder was cured at 180°C for 45 min., securing the powder to the substrate to give the VLS substrate. The binder does not react chemically with the promoter, but serves as a matrix to hold the promoter onto the substrate.

The substrate prepared by this method Fig. 4 exhibited inhomogeneity in the broad particle size range of the powder and particle clumping, translatable into a wide range of fiber diameters, and poor distribution of the powder, resulting in unused portions of the substrate that would reduce fiber yields. The dip or brushing method of applying the binder was also difficult to reproduce in terms of binder weight. Multiple substrates were prepared in order to achieve paired substrates suitable with regards to correct binder weight for use in the VLS process.

The substrates prepared as in Comparative Example B were used in a VLS reaction according to the above procedure to produce SiC fibers. When binder weight was less than 45mg, there were spots of no growth and less dense growth overall. When the binder weight was 60mg or greater, a considerable amount of black, fuzzy undergrowth appeared on the substrate among the fiber.

It should be noted that Figs. 1-4 were taken at various magnifications in order to resolve the particles present, and a one to one comparison should not be made. However, it can be seen overall that the particle size and particle distribution of Figs. 1 and 2 substrate surfaces prepared according to the inventive method are more uniform and homogeneous than those exhibited in Figs. 3 and 4.

Examples 14-16

Direct comparison was made of the method to prepare VLS substrates according to the present invention versus the conventional binder method, with regards to fiber yield, utilizing such substrates in a VLS silicon carbide fiber production process.

In each example, one half the substrate was prepared by the binder method, and the other half by the inventive sol method. Results of the VLS production of silicon carbide fibers are reported in Table II.

Graphite substrates 11.25 inches by 2.125 inches were divided along the long axis, and masking tape covered one side. The uncovered side was immersed in the acryloid resin (3g Cabosil, 100g resin, 150g methylethylketone) and cured for 5 minutes in a preheated 50°C oven. The tape was removed and the substrate was cured for another 5 minutes. Fifty milligrams of the standard $Fe_{80}Si_{20}$ fiber growth promoter material was sprinkled on the substrate, the sol side being covered with a strip of paper. The binder side was completed by curing at 120°C for 30 minutes.

One hundred milliliters of hydrous iron oxide/methanol sol with $Fe^{3+}$ concentration of 0.0938M was prepared for each substrate and allowed to settle. Prior to use, 43ml of supernatant was removed. Each sol side was coated with 5.8ml of stirred sol by dropper. The concentration and amounts were selected such that each side (binder and sol) had approximately the same number of fiber growth promoter particles, with an equal mass loading per unit area. The sol was dried in air, at room temperature. (It should be noted that at silicon carbide VLS run conditions the iron oxide becomes an iron/silicon alloy prior to fiber production.)

The coated substrates were placed in a reactor in separate runs and were subjected to VLS conditions under an atmosphere of 81.7% $H_2$, 10.2% CO, 7.6% $N_2$ and 0.5% $CH_4$ at a flow rate of 3.0931/min and a temperature of 1450°C for 8 hours. A test run of full-sol substrates confirmed that each substrate side could produce approximately equal fiber yields. The sol side of the substrates in each of the foregoing examples, however, exceeded the binder side of the same substrate in fiber production, as set forth in Table II.

TABLE II

| Example | Gross Yield (mg.) | | Yield $(g/ft^2-hr)$ | | Percent Improvement |
|---|---|---|---|---|---|
| | sol | binder | sol | binder | |
| 14 | 323 | 274 | 0.486 | 0.413 | 17.7 |
| 15 | 518 | 321 | 0.780 | 0.483 | 61.5 |
| 16 | 509 | 341 | 0.766 | 0.514 | 49.0 |

Where promoter material particle size and loading has been kept essentially the same, the substrates prepared by the method of the present invention, when utilized in the VLS silicon carbide process, consistently outperformed substrates prepared according to the conventional "binder" method with regard to fiber yield.

From the examples described above, it is apparent that the method of the present invention results in substrates for the VLS reaction having improved uniformity of fiber growth promoter particle size and distribution. The inventive method permits the incorporation of more than one metal component into the promoter without adversely affecting particle size or distribution. The results of the inventive method are more reproducible than those of conventional methods. The method provides an easy procedure for preparing substrates, and a less expensive one compared to use of more expensive sized alloy powders or capital equipment.

The VLS process of the present invention results in improved fiber yields. Additionally, the VLS process using the improved substrates minimizes the black undergrowth of material produced among SiC fibers and permits better control of fiber diameter.

## Claims

1. A method of preparing a substrate for the VLS preparation of inorganic fibers, which comprises applying to at least one surface of a substrate, a fiber growth promoter material precursor; characterised in that the fiber growth promoter material precursor is applied to the surface in the form of a sol comprising colloidal particles of less than or equal to 1 micron in size, said sol being capable of wetting the surface, which is thereafter dried.

2. A method of preparing inorganic fibres by a VLS process, which comprises preparing a substrate by a method as claimed in Claim 1, and contacting said substrate with gaseous components of said fibres at VLS reaction temperature.

3. A method as claimed in Claim 2 wherein said sol coated substrate is heat treated prior to contacting with said gaseous components.

4. A method as claimed in any one of Claims 1 to 3 wherein said sol coating is formed by adding a base to an alcohol solution of a salt of at least one metal selected from iron, manganese, nickel, cobalt, chromium, molybdenum, lanthanum and mixtures therefore to precipitate out colloidal hydrous oxides of said metal.

5. A method as claimed in any one of Claims 1 to 3 including forming a sol of colloidal hydrous metal oxide particles in a liquid, said metal oxide being said fiber growth promoter material precursor and said liquid being capable of dissolving a salt of said metal and of wetting the substrate surface as a sol.

6. A method as claimed in Claim 5 wherein said liquid contains a surfactant.

7. A method as claimed in Claims 5 or 6 wherein said metal is selected from iron, manganese, nickel, cobalt, chromium, molybdenum, lanthanum and mixtures thereof.

8. A method as claimed in claim 4 wherein said alcohol is selected from methanol, ethanol and propanol.

9. A method as claimed in claims 4 or 8 wherein said base is selected from ammonium hydroxide, tetramethylammonium hydroxide, tetraethylammonium hydroxide, tetrapropylammonium hydroxide, sodium hydroxide, calcium hydroxide, trimethylamine, triethylamine, ethylenediamine, ammonia, or mixtures thereof.

10. A method as claimed in any of the proceeding claims wherein said substrate is selected from graphite, glassy carbon, silicon carbide, silicon nitride and alumina.

11. A method as claimed in any of claims 2 to 10 wherein SiC fibers are produced, including the steps of contacting said coated substrate with silicon and carbon containing gases at a temperature of about 1300°C to about 1500°C.

**Patentansprüche**

1. Verfahren zur Präparierung eines Substrats für die VLS-Herstellung anorganischer Fasern, umfassend das Aufbringen einer Vorstufe eines das Faserwachstum fördernden Materials auf wenigstens eine Oberfläche eines Substrats, dadurch gekennzeichnet, daß die Vorstufe des das Faserwachstum fördernden Materials in Form eines Sols auf die Oberfläche aufgebracht wird, das kolloidale Teilchen einer Größe von 1 µm oder weniger umfaßt, wobei das Sol befähigt ist, die Oberfläche zu benetzen, die danach getrocknet wird.

2. Verfahren zur Herstellung anorganischer Fasern mittels eines VLS-Verfahrens, umfassend die Präparierung eines Substrats mittels eines in Anspruch 1 beanspruchten Verfahrens und das In-Berührung-Bringen des Substrats mit gasförmigen Komponenten der Fasern bei der VLS-Reaktionstemperatur.

3. Verfahren nach Anspruch 2, worin das mit dem Sol beschichtete Substrat vor dem In-Berührung-Bringen mit den gasförmigen Komponenten wärmebehandelt wird.

4. Verfahren nach irgendeinem der Ansprüche 1 bis 3, worin die Sol-Beschichtung in der Weise erfolgt, daß eine Base zu einer Alkohol-Lösung eines Salzes wenigstens eines aus Eisen, Mangan, Nickel, Cobalt, Chrom, Molybdän, Lanthan und deren Gemischen ausgewählten Metalls hinzugefügt wird, um kolloidale wasserhaltige Oxide des betreffenden Metalls auszufällen.

5. Verfahren nach irgendeinem der Ansprüche 1 bis 3, umfassend die Bildung eines Sols kolloidaler wasserhaltiger Oxid-Teilchen in einer Flüssigkeit, worin das betreffende Metalloxid die genannte Vorstufe eines das Faserwachstum fördernden Materials ist und die Flüssigkeit befähigt ist, ein Salz des betreffenden Metalls aufzulösen und die Substrat-Oberfläche als Sol zu benetzen.

6. Verfahren nach Anspruch 5, worin die Flüssigkeit ein Tensid enthält.

7. Verfahren nach den Ansprüchen 5 oder 6, worin das Metall aus Eisen, Mangan, Nickel, Cobalt, Chrom, Molybdän, Lanthan und deren Gemischen ausgewählt ist.

8. Verfahren nach Anspruch 4, worin der Alkohol aus Methanol, Ethanol und Propanol ausgewählt ist.

9. Verfahren nach den Ansprüchen 4 oder 8, worin die Base aus Ammoniumhydroxid, Tetramethylammoniumhydroxid, Tetraethylammoniumhydroxid, Tetrapropylammoniumhydroxid, Natriumhydroxid, Calci-

10

umhydroxid, Trimethylamin, Triethylamin, Ethylendiamin, Ammoniak und deren Gemischen ausgewählt ist.

10. Verfahren nach irgendeinem der vorhergehenden Ansprüche, worin das Substrat aus Graphit, glasigem Kohlenstoff, Siliciumcarbid, Siliciumnitrid und Aluminiumoxid ausgewählt ist.

11. Verfahren nach irgendeinem der Ansprüche 2 bis 10, worin SiC-Fasern erzeugt werden, umfassend die Schritte des In-Berührung-Bringen des beschichteten Substrats mit Silicium und Kohlenstoff enthaltenden Gasen bei einer Temperatur von etwa 1300 °C bis etwa 1500 °C.

**Revendications**

1. Méthode pour préparer un substrat pour la production de fibres inorganiques par le mécanisme VLS, qui consiste à appliquer, sur au moins une surface d'un substrat, un précurseur de matériau promoteur de croissance de fibres, caractérisée en ce que le précurseur de matériau promoteur de croissance de fibres est appliqué sur la surface sous la forme d'un sol comprenant des particules colloïdales d'une taille égale ou inférieure à 1 micron, ledit sol étant capable de mouiller la surface, qui est ensuite séchée.

2. Méthode pour préparer des fibres inorganiques par un procédé VLS, qui consiste à préparer un substrat par une méthode conforme à la revendication 1, et à mettre en contact ledit substrat avec des composants gazeux desdites fibres à la température de réaction VLS.

3. Méthode conforme à la revendication 2, caractérisée en ce que ledit substrat revêtu de sol subit un traitement thermique avant d'être mis en contact avec lesdites composants gazeux.

4. Méthode conforme à l'une quelconque des revendications 1 à 4, caractérisée en ce que le revêtement de sol est obtenu en ajoutant une base à une solution alcoolique d'un sel d'au moins un métal choisi parmi le fer, le manganèse, le nickel, le cobalt, le chrome, le molybdène, le lanthane et des mélanges de ces métaux, pour précipiter des oxydes colloïdaux hydratés dudit métal.

5. Méthode conforme à l'une quelconque des revendications 1 à 3, consistant à obtenir un sol de particules colloïdales d'oxyde métallique hydraté placées dans un liquide, ledit oxyde métallique étant ledit précurseur de matériau promoteur de croissance de fibres, et ledit liquide étant capable de dissoudre un sel dudit métal ou de mouiller la surface du substrat à la manière d'un sol.

6. Méthode conforme à la revendication 5, caractérisée en ce que ledit liquide contient un agent de surface.

7. Méthode conforme aux revendications 5 ou 6, caractérisée en ce que ledit métal est choisi parmi le fer, le manganèse, le nickel, le cobalt, le chrome, le molybdène, le lanthane et des mélanges de ces métaux.

8. Méthode conforme à la revendication 4, caractérisée en ce que ledit alcool est choisi parmi le méthanol, l'éthanol et le propanol.

9. Méthode conforme aux revendications 4 ou 8, caractérisé en ce que ladite base est choisie parmi l'hydroxyde d'ammonium, l'hydroxyde de tétraméthylammonium, l'hydroxyde de tétraéthylammonium, l'hydroxyde de tétrapropylammonium, l'hydroxyde de sodium, l'hydroxyde de calcium, la triméthylamine, la triéthylamine, l'éthylènediamine, l'ammoniac, ou des mélanges de ces substances.

10. Méthode conforme à l'une quelconque des revendications précédentes, caractérisée en ce que ledit substrat est choisi parmi le graphite, le carbone vitreux, le carbure de silicium, le nitrure de silicium et l'alumine.

11. Méthode conforme à l'une quelconque des revendications 2 à 10, dans laquelle des fibres de SiC sont produites, comprenant l'étape consistant à mettre en contact ledit substrat revêtu avec des gaz contenant du silicium et du carbone à une température d'environ 1 300 °C à environ 1 500 °C.

FIG. 1

FIG. 2

FIG. 3

FIG. 4